(19) **Europäisches Patentamt European Patent Office Office européen des brevets**

(11) **EP 2 395 533 B1**

(12) **EUROPEAN PATENT SPECIFICATION**

(45) Date of publication and mention of the grant of the patent:
**30.04.2014 Bulletin 2014/18**

(51) Int Cl.:
*H01H 59/00* (2006.01)    *H01P 1/12* (2006.01)
*H01H 1/20* (2006.01)    *H01H 1/00* (2006.01)

(21) Application number: **10401078.0**

(22) Date of filing: **09.06.2010**

(54) **Electrostatically actuated micro-mechanical switching device**

**Elektrostatisch betätigte mikromechanische Schaltvorrichtung**

**Dispositif de commutation micro-mécanique à actionnement électrostatique**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**14.12.2011 Bulletin 2011/50**

(73) Proprietors:
• **Fraunhofer-Gesellschaft zur Förderung der angewandten Forschung e.V.**
  **80686 München (DE)**
• **Sony Corporation**
  **Tokyo 108-0075 (JP)**

(72) Inventors:
• **Frömel, Jörg**
  **09131 Chemnitz (DE)**
• **Gessner, Thomas**
  **09113 Chemnitz (DE)**
• **Kaufmann, Christian**
  **09217 Burgstädt (DE)**

• **Leidich, Stefan**
  **09112 Chemnitz (DE)**
• **Nowack, Markus**
  **09509 Pockau (DE)**
• **Bertz, Andreas**
  **09123 Chemnitz (DE)**
• **Ikeda, Koichi**
  **Atsugi-shi**
  **Kanagawa 243-0014 (JP)**
• **Akiba, Akira**
  **Atsugi-shi**
  **Kanagawa 243-0014 (JP)**
• **Kurth, Steffen**
  **09380 Thalheim (DE)**

(74) Representative: **Steiniger, Carmen**
  **Kanzlei Dr. Steiniger**
  **Ricarda-Huch-Straße 4**
  **09116 Chemnitz (DE)**

(56) References cited:
**DE-A1-102007 013 102    DE-A1-102007 035 633**
**DE-B3-102006 001 321    US-A1- 2003 102 936**

**Description**

The present invention relates to an electrostatically actuated micro-mechanical switching device with movable elements formed in the bulk of a substrate for closing and releasing at least one Ohmic contact by a horizontal movement of the movable elements in a plane of the substrate; the switching device comprising: a drive with comb-shaped electrodes, wherein the electrodes comprise fixed driving electrodes and movable electrodes; a movable push rod being mechanically connected with the movable electrodes and extending through the electrodes; a movable contact element being mechanically connected with one side of the push rod; at least one restoring spring being mechanically connected with the push rod; a signal line and a ground line, wherein the signal line comprises two parts being interrupted by a gap.

Micro mechanical switches for electric signals, i.e. radio frequency (RF) signals, are known from several publications. The basic concepts can be divided into categories based on the method of generating the force used for mechanical actuation, on fabrication technology and on the type of contact. In general, the contact of the switch can be of Ohmic nature, realized by metal-metal-contacts or of capacitive nature. In the case of a capacitive switch, the signal flow is controlled by a capacitance contrast either connected in series or in parallel with the transmission line.

As mentioned above, the present invention is related to electrostatically actuated devices with Ohmic contacts. The fabrication technology of interest is widely described as "bulk technology". In bulk technology, the functional elements of the mechanical domain are structured into the depth of the wafer material whereas so called surface technologies transfer mechanical elements into previously deposited layers of material.

Following major demands on micro mechanical switches have been derived from potential applications: low actuation voltage in the range below 5 V, negligible actuation power consumption, short switch time of less than 10 $\mu$s, perfect isolation in dc-range, isolation better than -30 dB in RF range, less than 0.2 $\Omega$ on resistance, power loss in on state better than -0.5 dB, negligible cross talk from actuation to the signal ports, high self actuation voltage of more than 10 V, life time of more than 1 Billion switch cycles, and extremely small outline in case of integrated switches or small footprint of the packaged switch component.

Due to several reasons, it is desirable to maximize the actuation force. Most RF applications require fast switching of the signal pathways. All functional elements of a mechanical switch provide inertial mass. The linear relation between force and acceleration implies that high force will lead to faster reaction. It is also known that the reliability of an Ohmic contact is significantly affected by the contact force. Low contact forces result in high contact resistances and possibly excessive heating due to current flow. Low forces also lead to small contact area. The actual contact may occur only at small surface asperities which can lead to early failure of the device.

One can conclude that the generation of a relatively high actuation force plays a pivoting role in case of Ohmic switches since low switch time, low contact resistance, and high reliability is achieved by sufficient actuation force to accelerate the mechanically movable structures fast enough, to obtain a sufficient contact force and to overcome the adhesion forces of the closed contacts when opening them. Low actuation voltage is contrary to high actuation force and challenging therefore.

The electrostatic actuation relies on forces between differently polarized electrodes. A difference of potential between two conducting entities causes an electric field which stores energy. If a change of position of the conducting entities would influence the amount of energy stored into the field, i.e. the capacitance, an attractive force will act on both entities. This force has an orientation that it would lead, if not mechanically prevented, to a movement into the spatial direction of the energy gradient. The situation can be described by the following equation:

$$F = \frac{1}{2}U^2 \, \delta C\!\!\Big/\!\!\delta x \, , \qquad\qquad (1)$$

wherein $F$ is the mechanical force, $U$ the actuation potential, x the mechanical travel and C the electrical capacitance.

According to equation (1) the force can be increased by increasing the actuation potential or by increasing the capacitance gradient. The increase of the voltage is commonly subject to limitation determined by the application. A common design goal is to maximize the gradient of capacitance. Assuming a simple parallel plate capacitor and one degree of freedom the gradient of capacitance can be described as follows:

$$\delta C\!\!\Big/\!\!\delta x = \frac{\varepsilon_0 \varepsilon_r A}{(g_0 - x)^2} \, , \qquad\qquad (2)$$

wherein $\varepsilon_0$ is the permittivity of vacuum, $\varepsilon_r$ the relative permittivity of the dielectric material, $A$ the surface area of the electrodes, and go the initial separation. Since only gases with $\varepsilon_r \approx 1$ or vacuum are suitable dielectric materials, the general design goal is to maximize the surface area and to minimize the electrode separation.

An obvious way to increase the electrode area is to use larger electrodes. At least two facts exclude this method from a practical solution. Increasing the physical dimension of functional elements usually leads to a higher size of the devices on the wafer. The consequences are higher costs and lower fabrication yield. Beside fabrication issues, bigger devices will also raise integration difficulties.

A common approach to increase the electrode area without increasing the lateral size is to use comb shaped electrodes.

The capacitance of the combs can be calculated by

$$C_c = \frac{\varepsilon_0 \cdot l \cdot th \cdot 2 \cdot n}{g_{0c}} \ , \tag{3}$$

where $l$ is the length of the combs, $th$ the thickness of the combs into the depth of the wafer, $g_{0c}$ the separation of the combs, and n the number of comb pairs. Assuming the same lateral dimension, the capacitance of a parallel plate capacitor can be calculated by

$$C_p = \frac{\varepsilon_0 \cdot l \cdot n \cdot (2w + 2g_{0c})}{g_{0p}} \ , \tag{4}$$

wherein $w$ is the width of combs and $g_{0p}$ the separation of the electrodes. The comb shape electrode provides more capacitance per unit area than a parallel plate capacitor if the following condition is fulfilled:

$$\frac{C_c}{C_p} = \frac{g_{0p} \cdot th}{g_{0c}(w + g_{0c})} > 1 \ . \tag{5}$$

Rearranging (5) and substituting the ratio of $th$ and $g_{0c}$ by the $AR$ the aspect ratio the following relation can be derived:

$$g_{0p} > \frac{w + g_{0c}}{AR} \ . \tag{6}$$

Relation (6) states that the advantage of comb shape electrodes directly depends on the maximal possible aspect ratio of the etching process. Assuming technologically feasible figures for the relevant parameters as $g_{op}$=1µm, $w$=1µm, $g_{0c}$=4µm, and $th$=40pm ($AR$=10) the comb shaped design provides 8 times higher capacitance per unit area. It can be concluded that comb shaped electrodes are advantageous in terms of obtaining high actuation capacitance.

However, regarding electrostatic actuation, the high capacitance only serves as an intermediate result. According to equation (1) the force is proportional to the gradient of capacitance. A symmetric design, as used for the previous calculations, does not yield any net force in the direction of interest, i.e. orthogonal to the orientation of the comb. The obvious solution to break the symmetry is to use an asymmetric layout, i.e. $g_{0c}$ is different at both sides of the combs. Since $g_{0c}$ is usually selected as small as technologically possible, different $g_{0c}$ commonly means increasing $g_{0c}$ at one side. A more elegant approach to create asymmetric separation is to fabricate symmetric combs with minimal separation and displace the movable structure in a post processing step. This principle is called gap reduction in the following.

It is easily possible but somewhat lengthy to derive analytic descriptions for the ratio of forces obtained by the comb shape design and by the parallel plate capacitor. However, referring to the earlier mentioned numeric example, the actuation forces equal if the movable structure is deflected by 2.1 µm. At 3 µm deflection and therewith 1 µm remaining electrode separation, which is a practically proven safe minimal number, the force of the comb shape design is 4 times higher. It can be concluded that the technique of gap reduction allows transferring the advantage of a high capacitance successfully into high mechanical force.

Beside high force, gap reduction has an additional important advantage. By bringing the movable and solid elements closer together, the remaining travel of the contact elements and therewith the switching time is reduced. Ohmic contact switches do only require small travel for reliable switching. Even considering surface roughness, flexibility, and electric break through the minimal travel is usually one order of magnitude smaller than the minimal $g_{oc}$.

One possible solution to implement gap reduction is shown in the document US 2009/0219113 A1. The document describes a movable structure that is deflected out of its initial position. The motion is stopped by contact elements which are called stoppers in the following. The existence of stoppers might appear contradictorily since the separation to the movable element needs to be smaller than the initially defined minimal separation. However, it is practically possible to locally deviate from the design rules. The term "locally" means that the design at the location of the stoppers is investigated by the designer very carefully. The surrounding elements need to be specially adapted to the requirements of the stoppers. Consequently, it is not possible to fabricate that small separation at any location. The design rules remain.

The practical suitability of a gap reduction mechanism is defined by the periphery that is required for one time actuation and by the technique to permanently maintain the state of reduced gap. The additional periphery should consume only a small amount of wafer area to not counteract the advantage of the general concept. The latching mechanism should not rely on the application of permanent driving signals. Otherwise, this would lead to continuous power consumption or to possibly unknown states after failure of the supplies.

A technique to maintain deflected states of a laterally movable entity is described in the document DE 60 2005 002 277 T2. The mechanical latching is the result of form-fitting between mechanical structures. A disadvantage of the concept becomes obvious, if a lateral spacing according to the minimal separation is predetermined. In this case mechanical latching at intermediate position, i.e. fractions of $g_{0c}$, is difficult to implement. The large size and complex shape of the form-fitting elements do not qualify for a local deviation of the design rules.

Independent of the actual implementation (parallel plate or comb shaped electrodes) the actuation mechanism needs to be coupled to the contact elements. The term "contact elements" describes metallised structures that are driven into physical contact to implement the switching function. There are good reasons to implement some kind of elasticity between the actuator and the contact elements.

The documents US 2003/098618 A1 and US 2005/0099252 A1 describe the use of a flexible contact to implement a progressive spring. The additional elasticity is inactive in the open-state of the switch. Initially, the actuator only needs to provide a force that deflects the main spring, i.e. the spring that connects the contact with the frame. The actuation voltage can be low. At the moment of contact, the contact elasticity comes into action. The travel of the actuator is not stopped. The separation between the driving electrodes continues to decrease. Consequently, the force increases. Due to mechanical series connection, the force acts on the contact in its full extend.

Most implementations of switches using surface technologies rely on physical contact of the driving electrodes. An isolation layer in between prevents electrical short. However, this layer is commonly subject to electric charging. The charging of the isolation prevents the switch from being released. This mode of failure is usually called sticking. The invention described in the documents US 2003/098618 A1 and US 2005/0099252 A1 uses the progressive spring not only for an increase of the contact force but preferably for an increase of the release force. It is important to notice, that the additional release force only acts on the actuation electrodes. The contact itself is released only by the force of the main spring which is usually low to keep the actuation voltage low.

The document WO 2008/110389 A1 describes a switching device of the above mentioned type and according to the preamble of claim 1. The document includes the idea to provide an element for an increase of the mechanical force and an assembly for a high frequency isolation of the switch between the electrostatic drive and the contact beam. The element for the increase of the mechanical force is either a lever mechanism between the electrostatic drive and the contact beam and/or an elastic element with a progressive effect or a clutch mechanism provided in the flux of forces between the electrostatic drive and the contact beam, respectively. The high frequency isolation is realized by an interruption of the metallization on the lever mechanism.

Many applications for electrostatically actuated MEMS switches require low insertion loss and high isolation (e.g. -0.5 dB and -30 dB, respectively) in a wide frequency range (e.g. 1 MHz ... 100 GHz). Low switch time (e.g. less than 10 $\mu$s) should be achieved with low actuation voltage (e.g. 5 V), and the switch has to be designed so that contact wearout and contact sticking do not limit the reliability to less than $10^9$ switch cycles. MEMS switches in a shunt configuration in which the contact element of the switch is permanently connected with the signal line and serves for an electric connection with the ground potential of the switch basically comply with the frequency range and the isolation requirements, but following difficulties arise:

Low switch time and sufficient reliability make relatively strong actuation force necessary. This is in contrast to the demands for low actuation voltage. A possible solution is the application of horizontally actuating comb drive electrodes, because of the relatively high electrode area in comparison to vertically actuating electrodes. But the mechanical coupling between the electric shunt contact and the actuator has to be achieved without disjoining the signal line, since the complete frequency band is to be transmitted, and the line impedance should vary as small as possible.

A further possible solution would be a flexible part of the signal line, which may carry the shunt contact and which is mechanically coupled to the actuator, and provides an additional force due to its bending when the switch is actuated. This force counteracts the actuation force and reduces the contact force, resulting in higher necessary actuation voltage. An extremely narrow and long flexible part of the signal line would be a way out, but the impedance of this kind of signal line strongly deviates from feeding lines impedances in most cases.

It is therefore the object of the present invention to provide a micro-mechanical switching device in shunt-configuration with low loss, high isolation in a wide frequency range, low switch time at low actuation voltage and sufficient reliability, wherein the switching device is designed that way that the line impedance of the signal line and its variation is as small as possible.

The object is solved by an electrostatically actuated micro-mechanical switching device of the above mentioned type according to claim 1 and the dependent claims wherein the switching device is in shunt-configuration for closing and releasing the Ohmic contact between the ground line and the signal line, wherein the contact element comprises a movable contact beam extending at least partially opposite to the signal line and being electrically and mechanically connected to both parts of the signal line, respectively; the ground line comprises at least one contact bar leading through the gap of the signal line for forming the Ohmic contact between the contact beam and the ground line; and a contact metallization is provided at least on top and on the side walls of the contact beam, of the signal line and of the ground line.

According to the present invention which provides a switching device in shunt-configuration with a contact beam which is at its both ends mechanically and electrically connected with the signal line, which is typically but not necessarily a coplanar strip signal line, and which is furthermore connected with the movable push rod being actuated by the electrodes. The contact beam is bended by the actuation force. The dimensions of the contact beam are chosen that way that it provides high elasticity, and therefore low force counteracting the actuation. Nevertheless, the contact beam provides additional restoring force. This force can be used to prevent contact sticking. However, too high restoring force causes high minimum actuation voltage which is not desirable. It is therefore necessary in accordance with the present invention to use a rather long and thin contact beam as described below with reference to the drawings. Such a thin beam has high inductance.

At lower frequencies and DC, the inductance of the contact beam is not critical. It is critical at high GHz frequencies. Therefore, the present invention suggests a switching device wherein a significant part of the signal line is arranged in parallel to the contact part in order to form an additional capacitive coupling for high frequency. Thus, an additional current path is created which reduces the inductive influences of the long contact beam. It is therefore possible to fulfil the demands for low stiffness without suffering from mismatch of the line impedance.

The isolation of Ohmic switches in high frequency range is limited by capacitive cross-talk from input port to output port. Therefore, in the present invention two contact sets are applied in series within the signal line which are both open in the off-state and closed in the on-state. The contacts are located on both sides of an elastic contact beam.

The resistance of the movable contact beam contributes to the on-resistance of the switch and to power loss in on-state. Therefore, the electric connection between the both contacts at the contact beam or the resistance of the contact beam is in series to the signal line and would limit the performance of the switching device. Therefore, the present invention suggests the deposition of a metal on top and also on the side walls of the contact beam, of the ground line and of the signal line, resulting in a significant decrease of this resistance. That contact metallization can be realized for instance by metal sputtering after structuring of the contact beam. In this case, a shadow mask has to be applied for defining the metallization area. Alternatively, a relatively thick metal layer can be applied before structuring of the movable part of the switching device by electroplating. It may be used as contact material for the movable and the fixed contacts as well. However, that alternative solution includes the necessity of a protection of this layer during silicon etch processes and a possible contamination of the contact surface during subsequent processes.

In order to achieve high actuation force and low switch time, both the separation of the movable and the fixed contact tips in the non activated state and the separation of the movable and the fixed actuation electrodes should be as small as possible. Fabrication technology restrictions limit the minimum size of the spacing between the electrodes and between the contact tips. Thus, according to a favourite embodiment of the present invention, a gap reduction mechanism which is activated at the end of the fabrication sequence is applied to achieve a lower separation. The gap reduction mechanism comprises a movable frame being provided at a fixed end of each restoring spring and surrounding at least partially one fixed sticking pad, wherein the movable frame is opposite to at least one additional attracting electrode and elastically suspended so that the movable frame moves towards the sticking pad when an activation voltage is applied to the additional attracting electrode, wherein the movable frame comes to rest at the sticking pad at the side of the connection between the movable frame and the restoring spring, and wherein the sticking pad and the movable frame are permanently joined in that constellation by micro welding. After performing the gap reduction procedure with every movable frame, the driving electrode separation and the contact separation are permanently reduced. Since the sticking pads are provided that way that they come into contact with the movable frame at the side of the connection between the movable frame and the restoring spring, the influence of fabrication tolerances to the restoring force can be reduced.

In a particular embodiment of that construction, the sticking pads comprise a doping at their upper surface which is higher than the doping of the substrate material of the switching device. This can be used to localize the current of micro welding to smaller volume and therewith reduce the required energy and voltage, respectively.

In a variant of that construction, the movable frame is divided into two sections in order to enhance the mechanical stability and to reduce influences of fabrication tolerance.

Furthermore, if the side of the movable frame which is facing towards the gap reduction electrode is significantly wider compared to the other sides, the mechanical stiffness can be enhanced and undesirable bending and pull in due to the electrostatic force can be prevented. The side of the frame, which comes in contact to the sticking pads is realized to provide elasticity for a close contact to both sticking pads even when fabrication tolerances lead to different separations of the sticking pads to the corresponding side of the movable frame.

Because of low leakage currents, electric discharges during handling or during electrostatically assisted wafer level package procedures like anodic bonding may damage the electrodes or the contacts of the switching device. Therefore, in a further embodiment of the present invention metal bridges being released from the substrate by underetching are provided between electric lines which are electrically connected to fixed and to the movable electrodes during fabrication and/or handling of the switching device. According to a yet further embodiment, metal bridges with undercut are provided between electric lines which are electrically connected to the signal line and the ground line during fabrication and/or handling of the switching device. The metal bridges prevent voltage potential between the actuation electrodes or between the contacts during fabrication and handling. Thus, electric discharges and damages during fabrication and handling of the switching device as mentioned above can be significantly reduced if not eliminated. Since the metal bridges are undercut by a trench in the substrate, the heat conductivity and the thermal time constant of the metal bridges can be reduced.

In an alternative, the electric lines which are connected to the fixed and the movable electrodes, and the signal and the ground line, respectively, are electrically connected by contact windows in an isolation layer of the switching device and subsequent metallization to the substrate material during handling and/or wafer level packaging of the switching device to reduce electric discharges and damages.

If in that construction at least one metal bridge being released from the substrate by underetching is inserted into the connection path to the contact windows, the metal bridges can be burned out by a current which has to be fed by a designated contact at the end of the fabrication and handling process of the switching device.

It is especially advantageous if the contact windows are formed by a locally doped region at an upper surface of the substrate, the locally doped region being connected by a metal, wherein the metal comprises an opening over the doped region. The locally doped region provides a reduced contact resistance of substrate material beneath the contact windows. The opening can be small and will be used for a further etch step at the end of fabrication procedure to underetch the contact window totally as an alternative arrangement to interrupt the electrical connection between the fixed and the movable electrodes, and between the signal and the ground line.

The resistance between the actuation terminal and the comb electrodes and the capacitance of the actuation electrodes both lead to a time constant of the electric system and to increased switch time. To overcome this difficulty, the electrodes of the switching device consist of silicon, wherein the silicon material is locally doped in the area of the drive. This results in reduced resistance and a decrease of the time constant of the electrical system.

The restoring springs provide a force when switching into the deactivated state, which is sufficiently high for contact separation and for overcoming the adhesion force of the contacts. The force of the restoring spring counteracts the force of the actuator and therewith reduces the contact force in the actuated-state. Consequently, it is desirable to use restoring springs with low stiffness. To be able to use springs with low stiffness without risking contact sticking due to adhesion forces, in an embodiment of the present invention an elastic beam element is provided between the push rod and contact tip(s) of the contact beam, wherein the mass of the push rod and the movable electrodes is more than three times higher than the mass of the contact beam and the contact tip(s). The elastic contact beam is compressed by the force of the actuator in the actuated state. At the time of switching into the non-actuated state, the electrodes and the push rod accelerate under the force of the restoring springs and of the compressed elastic contact beam. Initially, the contacts remain closed. Assuming sticking contacts, the separating force is temporarily amplified by the momentum of the electrodes and of the push rod.

Since the present invention includes a switching device in shunt-configuration, the contact metallization leads to strong capacitive coupling between the signal line and the ground line. Therefore, in another embodiment of the present invention, the signal line and/or the ground line are divided into two sides of strips at a location of the contact metallization, wherein the strips are separated in their depth from the substrate. This configuration leads to much lower coupling capacitance. The signal line or the ground line is divided into strips at the location of contact metal deposition. The strips are that narrow that under etching is easily possible. Separation from the substrate is required to avoid electrical connection between the strips. All but one of the strips per side is not electrically isolated to the RF electrodes. Only the outmost strip is electrically connected. The separation into strips yields lower coupling area and lower capacitance, respectively. The isolated strips cause a series connection of the coupling capacitance between the RF signal line and the strips and the capacitance between the RF ground and the strips. The series connection of capacitance yields a smaller capacitance as the original ones.

A hermetic sealing of the devices by WLP makes it usually necessary to have vertical vias in the substrate or in the cover which limits scaling down the outline. To overcome this in a specific example of the present invention, lines to electric terminals of the switching device are arranged in flat grooves within a sealing area of the switching device and are isolated by an isolation layer to the substrate and a further isolation layer covering the lines, wherein the further isolation layer is partly removed so that the surface of the substrate is flat in the line region. This leads to the formation of buried metal lines. Wafer level packaging by anodic bonding which requires very flat surfaces becomes possible as a consequence.

In another embodiment of the present invention, the ground line is intersected by a slot extending in the direction of the push rod.

In accordance with another favourite embodiment of the present invention, the signal line of the switching device is interrupted at two locations by a gap respectively, and that there are two contact elements each comprising a movable beam extending at least partially opposite to the signal line and being electrically and mechanically connected to both parts of the signal line, and also mechanically connected to the push rod and therefore synchronously driven by the movable electrodes; wherein the ground line comprises at least one contact bar at the location of each gap of the signal line for forming the Ohmic contact between the contact beam and the ground line. Thus, the switching device of the present invention can be used in double contact shunt configuration.

The accompanying drawings are included to provide a further understanding of embodiments of the present invention and are incorporated in and constitute a part of this specification. The drawings illustrate embodiments of the present invention and together with the description serve to explain the principles of the invention. Other embodiments and many of the intended advantages will be readily appreciated as they become better understood by reference to the following detailed description. The elements of the drawings are not necessarily to scale relative to each other. Equal or similar elements or details of the illustrated switching devices are identified with same or like reference numerals. To avoid repetition, the description of these elements or details which has been made with regard to a specific figure is also applicable for the other figures if not absolutely excluded.

Fig. 1    illustrates schematically a plan view of a basic structure of an electrostatically actuated micro-mechanical switching device in shunt-configuration according to an embodiment of the present invention.

Fig. 2    illustrates schematically a plan and a cross-sectional view of a switching device according to an embodiment of the present invention with a shown contact metallization area.

Fig. 3    illustrates schematically a plan view of a switching device according to a further embodiment of the present invention with a mechanism for gap reduction before activation of that mechanism.

Fig. 4    illustrates schematically the switching device of Fig. 3 after activation of the mechanism for gap reduction.

Fig. 5    illustrates schematically a plan view of a switching device according to another embodiment of the present invention with metal fuses shown also in a crosssectional view.

Fig. 6    illustrates schematically a plan view of a switching device according to yet another embodiment of the present invention with metal fuses shown also in a cross-sectional view and high resistance current path.

Fig. 7    illustrates schematically a plan and a cross-sectional view of a switching device according to yet further embodiment of the present invention with locally doped silicon.

Fig. 8    illustrates schematically a plan view of a switching device according to a next embodiment of the present invention with an elastic beam in non-actuated state of the switching device.

Fig. 9    illustrates schematically the switching device of Fig. 8 in an actuated state.

Fig. 10    illustrates schematically the switching device of Figs. 8 and 9 during switching between an on- and an off-state of the switching device.

Fig. 11    illustrates schematically the switching device of Figs. 8 to 10 showing the force amplification by momentum.

Fig. 12    illustrates schematically a plan view of a switching device according to an embodiment of the present invention with a shown contact metallization area on the contact tips of the contact beam and on parts of the signal line and the ground line.

Fig. 13    illustrates schematically a plan view of a switching device according to another embodiment of the present invention with a strip shaped signal line and a contact metallization.

Fig. 14    illustrates schematically a plan view of a switching device according to a next embodiment of the present invention wherein the electric terminals are arranged in flat grooves and isolated by an isolation layer.

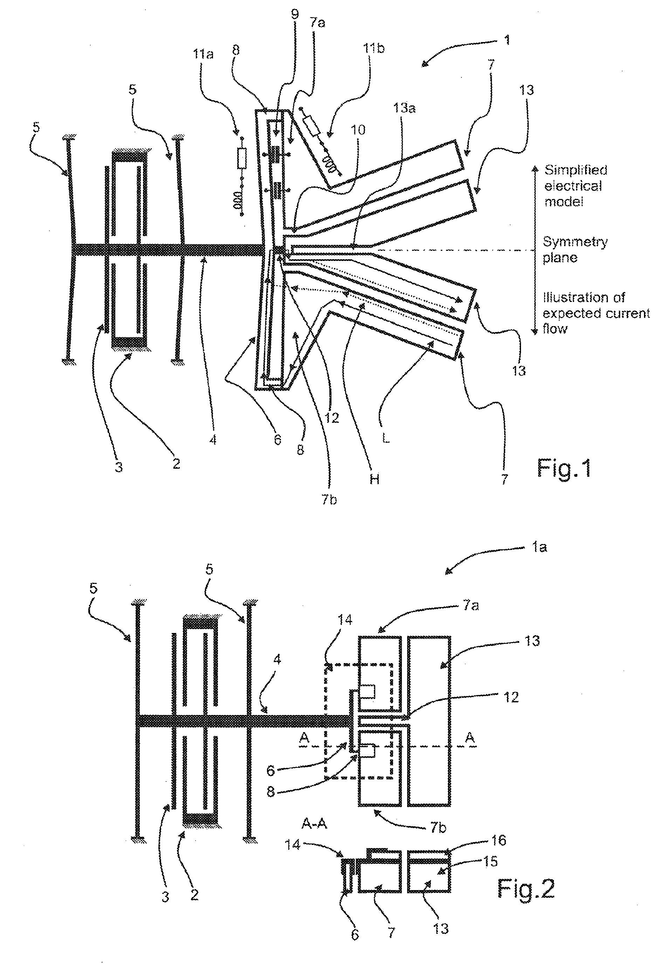

Fig. 1 illustrates schematically a plan view of a basic structure of an electrostatically actuated micro-mechanical switching device 1 in shunt-configuration according to an embodiment of the present invention. In Fig. 1, the shunt contact is closed.
The switching device 1 is formed in the bulk material of a crystalline silicon substrate. All movable parts of the switching device 1 consist of crystalline silicon and of metal. In other, not shown embodiments of the present invention, the switching device 1 can also be formed in another micro-mechanically processible material.
In the shown plan view, the switching device 1 is substantially symmetrically formed. The switching device 1 comprises a drive with comb-shaped electrodes 2, 3. The comb-shaped electrodes comprise fixed electrodes 2 being in direct mechanical connection with the substrate and movable electrodes 3 being separated from the substrate material. The movable electrodes 3 can be moved horizontally in a plane of the substrate. To simplify matters, in Fig. 1 only two pairs of fixed and movable electrodes 2, 3 are shown, wherein in practice the drive consists typically of a plurality of fixed and movable electrodes 2, 3 being opposite to each other, respectively. The minimum electrode separation given by technology constraints and the application related actuation voltage, both limit the electrostatic actuation force and the switch time as well as the contact reliability of the switching device 1 as a consequence.
The movable electrodes 3 extend from both sides of a movable push rod 4 extending centrally through the electrodes 2, 3. The push rod 4 is suspended on at least one restoring spring 5 which is on one side mechanically connected with the substrate. In the example of Fig. 1, two restoring springs 5 are provided at an end portion of the push rod 4, and further restoring springs 5 are provided at a middle portion of the push rod 4. In other, not shown embodiments of the present invention the number and the position of the restoring springs relative to the push rod 4 can be varied in comparison to the construction of Fig. 1.
On a non-suspended end of the push rod 4, a movable or flexible contact beam 6 is provided. The contact beam 6 extends transverse to the push rod 4 and at least partially opposite or in parallel to a signal line 7 of the switching device 1. The contact beam 6 has a specific inductance and resistance, identified schematically by the reference numeral 11 a in Fig. 1. The dimensions of the contact beam 6 are chosen that way that it provides high elasticity. Therefore, the contact beam 6 is relatively long and thin. The contact beam 6 comprises at its both ends two contact pins 8, respectively, at which the contact beam 6 is electrically and mechanically connected with the signal line 7. The isolation of Ohmic switches in high frequency range is limited by capacitive cross-talk from input port to output port.
Because, as mentioned above, the contact beam 6 extends at least partially opposite the signal line 7, there is a coupling capacitance 9, shown schematically in Fig. 1, between the signal line 7 and the contact beam 6.
In operation of the switching device 1, the contact beam 6 will be bended by an actuation force applied on the contact beam 6 by a co-operation of the electrodes 2, 3, the push rod 4 and the restoring springs 5. Because of the high elasticity of the contact beam 6, it provides only a low force counteracting the actuation.
The signal line 7 is divided into two parts 7a, 7b by a gap 10, wherein each contact pin 8 of the contact beam 6 is connected with one of these parts 7a, 7b. The signal line 7 is typically an RF electrode and has a specific inductance and resistance 11 b.
In the example of Fig. 1, a ground line 13 of the switching device 1 is intersected into two connected parts by a slot 13a which extends in the direction of the push rod 4. A contact bar 12 of the ground line 13 extends through the gap 10 and is in the shown actuated state in contact with the contact beam 6 and in a non-actuated state of the switching device 1 not connected with the contact beam 6. The restoring springs 5 counteract the actuation force of the drive and separate in the non-actuated state of the switching device 1 the contact beam 6 from the contact bar 12 of the ground line 13. In the example shown in Fig. 1, the ground line 13 is V-like formed and comprises a slot 13a between the axles of the "V". In other, not shown embodiments of the present invention, the signal line 7 as well as the ground line 13 can be formed in another way as it is shown in Fig. 1. But in all cases, the signal line 7 and the ground line 13 are provided on that side of the contact beam 6 opposite to the actuation mechanism of the switching device 1.
As shown for instance in Fig. 2, the contact beam 6 and parts of the signal line 7 and the ground line 13 are covered on top and on the side walls of these elements with a contact metallization 14.
As illustrated schematically by the continuous line L and the dashed line H in the lower part of Fig. 1, during operation of the switching device 1, there is a low frequency current path L and a high frequency current path H. The low frequency current path L flows from the signal line 7b through the broadest extension of the signal line 7b, through the contact pin 8, through the contact beam 6, and through the contact bar 12 on a long way to the ground line 13. The high frequency current path H flows on a short way from the signal line 7b through a small part of the contact beam 6, and through the contact bar 12 on a short way to the ground line 13.

The upper part of Fig. 2 also illustrates schematically a plan view of a switching device 1 a according to an embodiment of the present invention with a shown area of contact metallization 14. The lower part of Fig. 2 shows a cross-section along intersection line A-A of the upper part of Fig. 2. As shown, in the area of contact metallization 14, the contact beam 6 consisting of the substrate 15 material is covered with the metallization 14, wherein parts of the signal line 7 and the ground line 13 which consist in other area of the substrate 15 being covered with a metal layer 16 are additionally covered with the contact metallization 14 on top and on the side walls.

The contact metallization 14 leads to a significant decrease of the resistance of the contact beam 6, the signal line 7 and the ground line 13 in this area. As mentioned above, the contact metallization 14 covers also the sidewalls of the structures. This is required for obtaining an Ohmic contact between the contact beam 6 and the ground line 13 by lateral movement. The contact metallization 14 can be formed for instance by metal sputtering after structuring of the contact beam 6. A shadow mask has to be applied for defining the area of contact metallization 14. Alternatively, a relatively thick metal layer can be applied before structuring of the movable part by electroplating. It may be used as contact material for the movable and the fixed contacts as well. For this process, it is necessary to protect that metal layer during silicon etch processes, wherein a contamination of the contact surface during subsequent processes is possible.

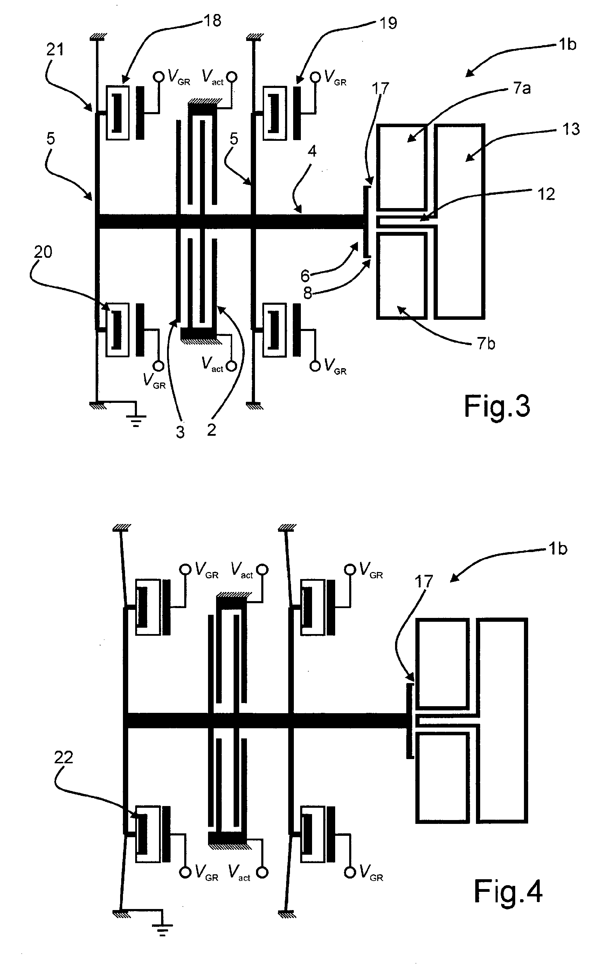

Fig. 3 illustrates schematically a plan view of a further switching device 1 b in accordance with a further embodiment of the present invention, wherein the switching device 1b comprises equal or similar elements and details like the switching devices 1, 1a of the Figs. 1 and 2, and wherein the switching device 1 b comprises additionally a mechanism for gap reduction shown before an activation of that mechanism. Fig. 4 illustrates schematically the switching device of Fig. 3 after activation of the mechanism for gap reduction.

In the state shown in Fig. 3, the contact beam 6 is not mechanically and electrically connected with the parts 7a, 7b of the signal line 7. Instead, there is a contact separation 17 before the below described gap reduction.

To realize a gap reduction resulting in a contact between the contact beam 6 and the signal line 7 as shown in Fig. 4, movable frames 18, additional attracting electrodes 19, and sticking pads 20 are inserted at the fixed ends 21 of each restoring spring 5, respectively. The movable frame 18 at least partially surrounds at least one sticking pad 20 and is opposite to at least one of the additional electrodes 19. The movable frame 18 is elastically suspended by further elastic beams and anchors so that the movable frame 18 moves towards the sticking pads 20 when an activation voltage is applied to the additional electrode 19 using the probe pads for the electric connection. Thus, the movable part of the switching device 1 b including the contact beam 6, the push rod 4, and the movable driving electrodes 3 are moved the same way leading to a reduced separation of the movable electrodes 3 to the fixed electrodes 2 at one side and to a reduced contact separation, as shown in Fig. 4, in the non-actuated state. As also shown in Fig. 4, the movable frame 18 comes to rest 22 at the at least one sticking pad 20. Then, the sticking pads 20 and the movable frame 18 are permanently joined by a micro welding procedure applying a current trough the sticking pads 20 and the movable frame 18. The sticking pads 20 can be heavily doped at their upper surface to localize the current of micro welding to smaller volume and therewith reduce the required energy and voltage, respectively.

In a particular, not shown embodiment, the movable frame 18 can also be divided into two sections in order to enhance the mechanical stability and to reduce influences of fabrication tolerance. Furthermore, the side of the movable frame 18 which is facing towards the additional electrode 19 is significantly wider compared to the other sides in order to enhance the mechanical stiffness and to prevent undesirable bending and pull in due to the electrostatic force. The side of the movable frame 18 which comes in contact to the sticking pad(s) 20 is realized to provide elasticity for a close contact to the sticking pad(s) 20 even when fabrication tolerances lead to different separations of the sticking pad(s) 20 to the corresponding side of the movable frame 18.

In the embodiment of Figs. 3 and 4, the sticking pads 20 are arranged that way that they come into contact to the corresponding side of the movable frame 18 near to the connection between movable frame 18 and restoring spring 5. It reduces the influence of fabrication tolerances to the restoring force 5.

As shown in Fig. 4, after performing the above described gap reduction procedure with every movable frame 18, the driving electrode separation and the contact separation 17 are permanently reduced, and the contact beam 6 is mechanically and electrically connected with the parts 7a, 7b of the signal line 7.

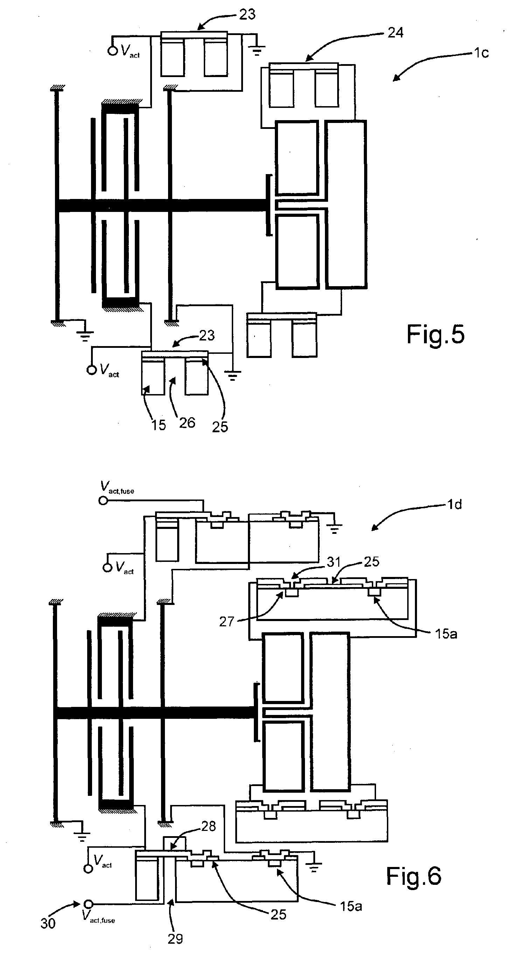

Fig. 5 illustrates schematically a plan view of a switching device 1c according to another embodiment of the present invention, wherein the switching device 1c comprises metal fuses in the form of metal bridges 23, 24 which are shown in a cross-sectional view, too.

The metal bridges 23, 24 which electrically connect the actuation electrodes 2, 3 and the contacts (signal line 7 and ground line 13) prevent voltage potential between the actuation electrodes or between the contacts during fabrication and handling. As shown in the cross-sectional views of the metal bridges 23, 24 in Fig. 5, the metal bridges 23, 24 are formed as free-standing bridges on an isolation 25 formed on the substrate 15 and are undercut by a trench 26 in the substrate 15 in order to reduce the heat conductivity and the thermal time constant of the metal bridges 23, 24. An initial step in the test of the switching device 1c is to load these metal bridges 23, 24 by an appropriate current in order to burn out them and to disconnect the electrodes 2, 3 and the signal line 7 and the ground line 13 from each other.

Fig. 6 illustrates schematically a plan view of a switching device 1d according to yet another embodiment of the present invention with metal fuses and high resistance current path.

In this embodiment, the signal line 7 and the ground line 13 are connected to the substrate 15 by connecting windows 27 in an isolation layer 25. Local doping of the substrate 15 material leads to a layer of doped silicon 15a beneath the contact windows 27 and reduces the contact resistance. Metal bridges 28 with undercut 29 are inserted into the connection to these contact windows 27. In order to remove this electric connection which may cause losses of the RF signal, the connection to the substrate 15 can be removed by a further etch step at the end of the fabrication procedure. During this etch step, the silicon underneath the contact window 27 is removed and therewith the connection between the metal and the substrate 15. In areas where an additional contact pad does not degrade the RF performance, the electrical connection to the substrate 15 can be removed furthermore by a burn out of the metal bridges 28. The metal bridges 28 can be burned out by a current which has to be fed by a designated contact pad 30. In the example of Fig. 6, the metal of the contact windows 27 has a small opening 31 in the middle which is used for a further etch step at the end of fabrication procedure to underetch the contact window 27.

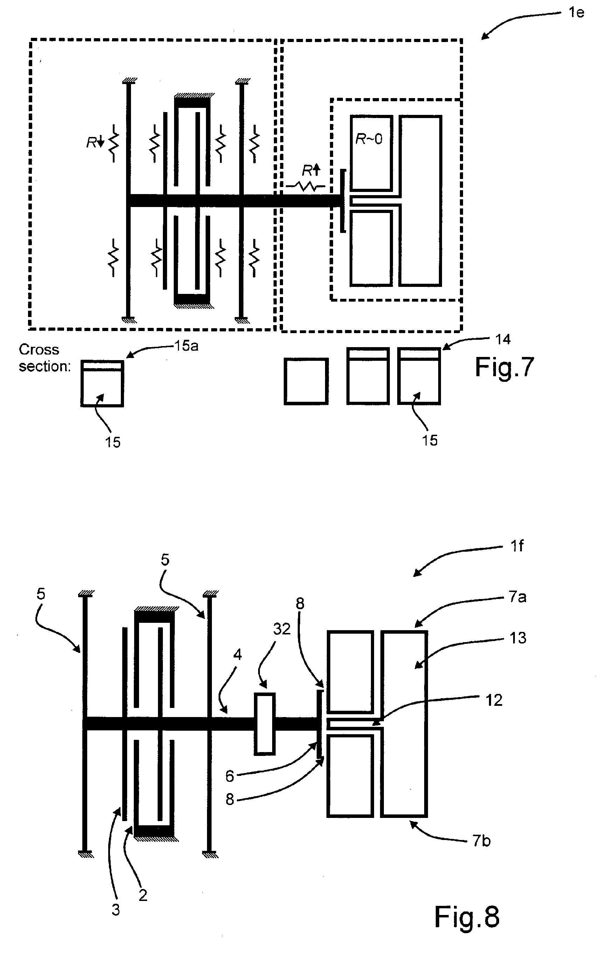

Fig. 7 illustrates schematically a plan and a cross-sectional view of a switching device 1e according to yet further embodiment of the present invention with locally doped silicon. In the switching device 1e, the substrate 15 is of silicon and the surface of the silicon material is locally doped in the area of the driving electrodes 2, 3. This results in reduced resistance and a decrease of the time constant of the electrical system.

Fig. 8 illustrates schematically a plan view of a switching device 1f according to a next embodiment of the present invention with an elastic beam in a non-actuated state of the switching device 1f.

The restoring springs 5 provide a force when switching into the deactivated state, which is sufficiently high for contact separation and for overcoming the adhesion force of the contacts. The force of the restoring spring 5 counteracts the force of the actuator and therewith reduces the contact force in the actuated-state. Consequently, it is desirable to use restoring springs 5 with low stiffness. To be able to use restoring springs 5 with low stiffness without risking contact sticking due to adhesion forces, in the embodiment of Fig. 8 an elastic beam element 32 is inserted between push rod 4 and the contact beam 6, and the push rod 4 and the movable comb electrodes 2, 3 are designed that way to have a significantly higher mass compared to the contact beam 6 with its contact tips 8.

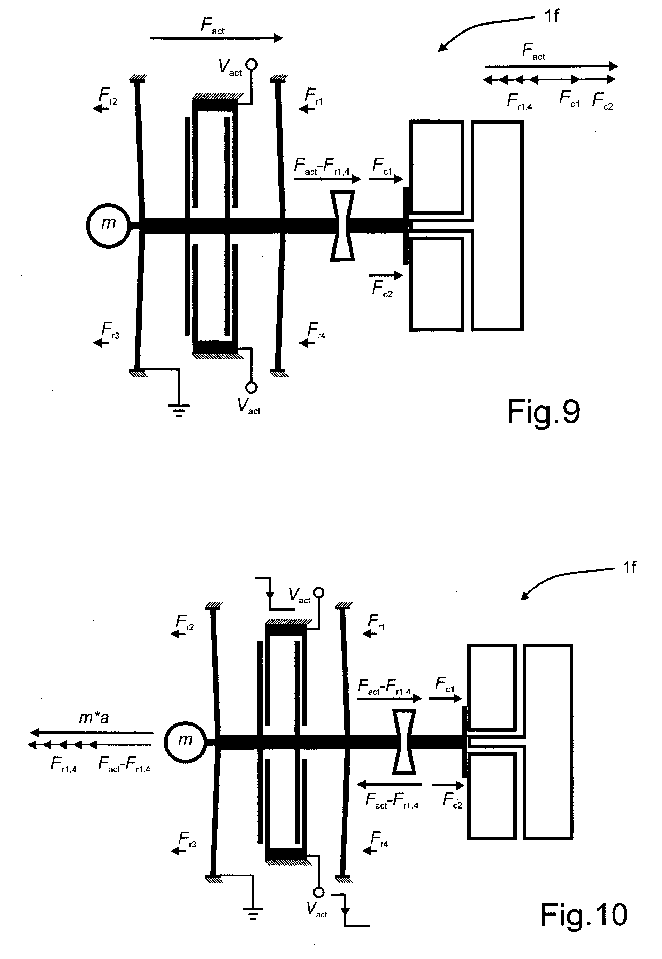

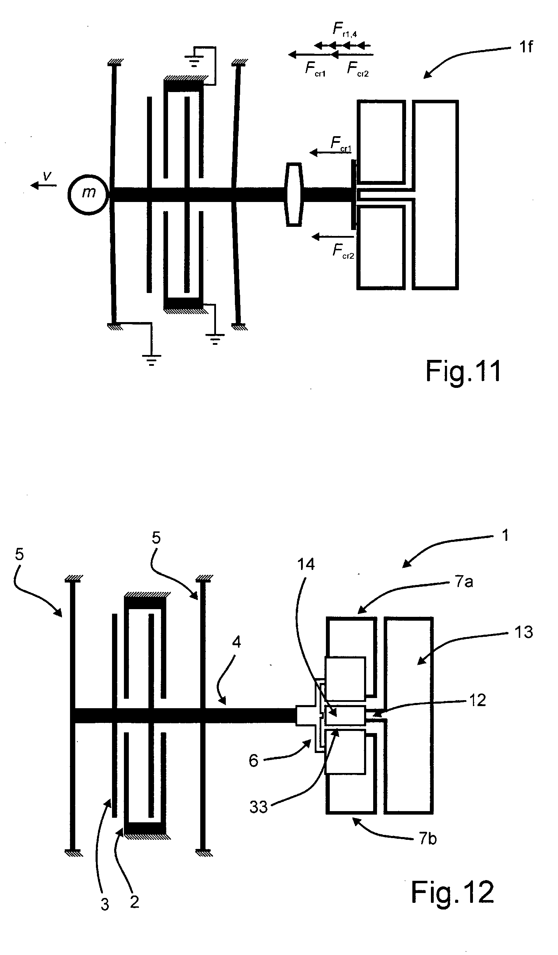

As shown in Fig. 9, the elastic beam element 32 is compressed by the force of the actuator in the actuated state. As shown in Fig. 10, at the time of switching into the non-actuated state the electrodes 2, 3 and the push rod 4 accelerate under the force of the restoring springs 5 and of the compressed elastic beam element 32. Initially, the contacts between the contact beam 6 and the parts 7a, 7b of the signal line 7 remain closed. Assuming sticking contacts, the separating force is temporarily amplified by the momentum of the electrodes 2 and of the push rod 4, as shown in Fig. 11, in order to separate the contact bar 12 from the contact beam 6 even in case of adhesion.

Fig. 12 illustrates schematically a plan view of a switching device 1 according to an embodiment of the present invention with a shown contact metallization 14 area on the contact tips 8 of the contact beam 6 and on parts of the signal line 7 and the ground line 13. There is a very small separation 33 between the metalized surface of the signal line 7 and the ground line 13. Therefore, the contact metallization 14 leads to strong capacitive coupling between the RF signal line 7 and the RF ground line 13. As shown in Fig. 12, the contact metal does not only cover the surface, it covers the side walls of the structure up to a certain depth as well. Assuming a depth of 50 $\mu$m, a separation of 3 $\mu$m and a length of 80 $\mu$m, the metallization yields a capacitance of 12 fF. This capacitance causes a coupling reactance of -220 j$\Omega$ which is sufficiently low to cause matching issues.

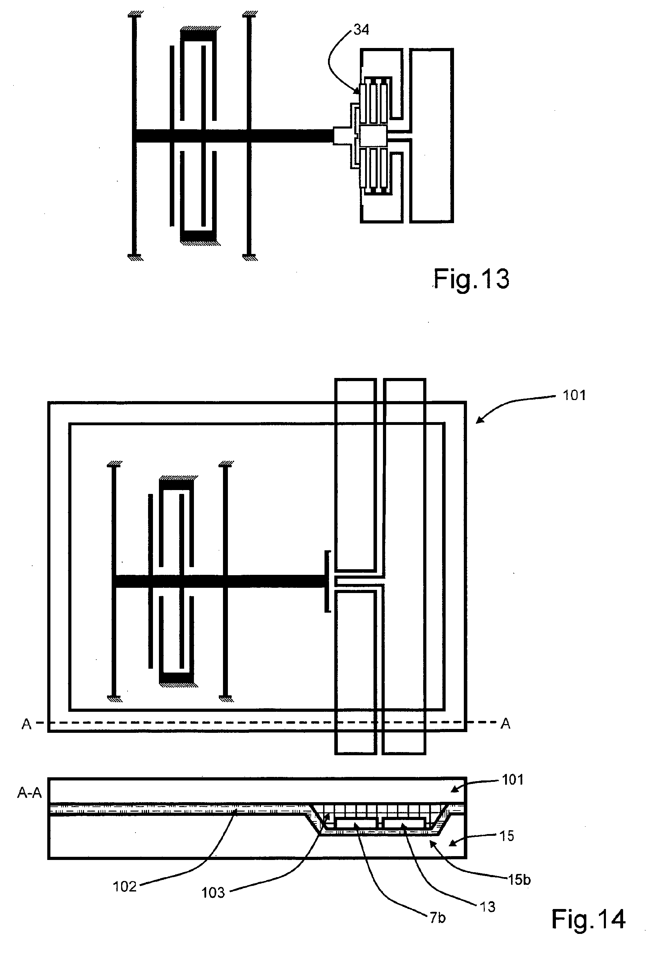

Fig. 13 shows a configuration with leads to much lower coupling capacitance. The signal line 7 or the ground line 13 is divided into strips 34 at the location of contact metallization 14. The strips 34 are that narrow that underetching is easily possible. Separation from the substrate 15 is required to avoid electrical connection between the strips 34. All but one of the strips 34 per side is not electrically isolated to the RF electrodes 7, 13. Only the outmost strip is electrically connected. The separation into strips 34 yields lower coupling area and lower capacitance, respectively. The isolated strips 34 cause a series connection of the coupling capacitance between the RF signal line 7 and the strips 34 and the capacitance between the RF ground line 13 and the strips 34. The series connection of capacitance yields a smaller capacitance in comparison to the original ones.

A hermetic sealing of the switching devices described above by wafer level packaging (WLP) makes it usually necessary to have vertical vias in the substrate 15 or in the cover 101 which limits scaling down the outline. To overcome this, in another embodiment of the present invention shown in Fig. 14 the metal lines to the electric terminals are arranged in flat grooves 15b within the sealing area of the switching devices and isolated by an isolation layer 102 to the substrate 15 for a lateral feed trough instead of vertical vias. A further isolation layer 103 covers the metal lines and is partly removed that way that the surface is flat in this region, wherein buried metal lines are formed. Wafer level packaging by anodic bonding which requires very flat surfaces becomes possible as a consequence.

**Claims**

1. Electrostatically actuated micro-mechanical switching device (1) with movable elements formed in the bulk of a substrate (15) for closing and releasing at least one Ohmic contact by a horizontal movement of the movable elements in a plane of the substrate (15); the switching device (1) comprising:

   a drive with comb-shaped electrodes (2, 3), wherein
   the electrodes (2, 3) comprise fixed driving electrodes (2) and movable electrodes (3);
   a movable push rod (4) being mechanically connected with the movable electrodes (3) and extending through the electrodes (2, 3);
   a movable contact element being mechanically connected with one side of the push rod (4), wherein the contact element comprises a movable contact beam (6),
   wherein the movable contact beam (6) extends at least partially opposite to the signal line (7);
   at least one restoring spring (5) being mechanically connected with the push rod (4);
   a signal line (7) and a ground line (13), wherein
   the signal line (7) comprises two parts (7a, 7b) being interrupted by a gap (10), wherein the ground line (13) comprises at least one contact bar leading through the gap of the signal line (7), and wherein
   a contact metallization (14) is provided at least on top and on the side walls of the contact beam (6), of the signal line (7) and of the ground line (13),
   **characterized in**
   **that** the switching device (1) is in shunt-configuration for closing and releasing the Ohmic contact between the ground line (13) and the signal line (7), wherein
   the movable contact beam (6) is electrically and mechanically connected to both parts (7a, 7b) of the signal line (7), respectively; and
   the at least one contact bar (12) leading through the gap (10) of the signal line (7) for forming the Ohmic contact between the contact beam (6) and the ground line (13).

2. Switching device of claim 1, **characterized in that** a movable frame (18) is provided at a fixed end (21) of each restoring spring (5) and surrounds at least partially one fixed sticking pad (20), wherein the movable frame (18) is opposite to at least one additional attracting electrode (19) and elastically suspended so that the movable frame (18) moves towards the sticking pad (20) when an activation voltage ($V_{GR}$) is applied to the additional attracting electrode (19), wherein the movable frame (18) comes to rest (22) at the sticking pad (20) at the side of the connection between the movable frame (18) and the restoring spring (5), and wherein the sticking pad (20) and the movable frame (18) are permanently joined **in that** constellation by micro welding.

3. Switching device of claim 2, **characterized in that** the sticking pads (20) comprise a doping at their upper surface which is higher than the doping of the substrate (15) material of the switching device (1 b).

4. Switching device of at least one of the claims 2 or 3, **characterized in that** the movable frame (18) is divided into two sections.

5. Switching device of at least one of the claims 2 to 4, **characterized in that** the side of the movable frame (18) which is facing towards the additional attracting electrode (19) is wider compared to its other sides.

6. Switching device of at least one of the preceding claims, **characterized in that** metal bridges (23) being released from the substrate (15) by underetching are provided between electric lines which are electrically connected to the fixed electrodes (2) and to the movable electrodes (3) during fabrication and/or handling of the switching device (1c).

7. Switching device of at least one of the preceding claims, **characterized in that** metal bridges (24) being released from the substrate (15) by underetching are provided between electric lines which are electrically connected to the signal line (7) and the ground line (13) during fabrication and/or handling of the switching device (1c).

8. Switching device of at least one of the preceding claims, **characterized in that** electric lines which are connected to the fixed electrodes (2) and the movable electrodes (3), and the signal line (7) and the ground line (13), respectively, are electrically connected by contact windows (27) in an isolation layer (25) of the switching device (1d) and subsequent metallization to the substrate (15) material during handling and/or wafer level packaging of the switching device (1d).

9. Switching device of claim 8, **characterized in that** at least one metal bridge (28) with undercut (29) is inserted into the connection path to the contact windows (27).

10. Switching device of claim 8 or 9, **characterized in that** the contact windows (27) are formed by a locally doped region at an upper surface of the substrate (15), the locally doped region being connected temporarily by a metal, wherein the metal comprises an opening (31) over the doped region, and wherein the doped region is at least partially removed after bonding of the switching device (1) in order to cut a short circuit between metal and bulk.

11. Switching device of at least one of the preceding claims, **characterized in that** the electrodes (2, 3) consist of silicon, wherein the silicon material is locally doped in the area of the drive.

12. Switching device of at least one of the preceding claims, **characterized in that** an elastic beam element (32) is provided between the push rod (4) and contact tip(s) (8) of the contact beam (6), wherein the mass of the push rod (4) and the movable electrodes (3) is more than three times higher than the mass of the contact beam (6) and the contact tip(s) (8).

13. Switching device of at least one of the preceding claims, **characterized in that** the signal line (7) and/or the ground line (13) are divided into two sides of strips (34) at a location of the contact metallization (14), wherein the strips (34) are separated In their depth from the substrate (15).

14. Switching device of at least one of the preceding claims, **characterized in that** lines to electric terminals of the switching device (1) are arranged in flat grooves within a sealing area of the switching device (1) and are isolated by an isolation layer to the substrate (15) and a further isolation layer covering the lines, wherein the further isolation layer is partly removed so that the surface of the substrate (15) is flat in the line region.

15. Switching device of at least one of the preceding claims, **characterized in that** the ground line (13) is intersected by a slot (13a) extending in the direction of the push rod (4).

16. Switching device of at least one of the preceding claims, **characterized in that** the signal line (7) is interrupted at two locations by a gap (10) respectively, and that there are two contact elements each comprising a movable beam (6) extending at least partially opposite to the signal line (7) and being electrically and mechanically connected to both parts of the signal line (7), and also mechanically connected to the push rod (4) and therefore synchronously driven by the movable electrodes (3); wherein the ground line (13) comprises at least one contact bar at the location of each gap (10) of the signal line (7) for forming the Ohmic contact between the contact beam (6) and the ground line (13).

**Patentansprüche**

1. Elektrostatisch betätigte mikromechanische Schaltvorrichtung (1) mit beweglichen Elementen, die in der Masse eines Substrats (15) ausgebildet sind, um wenigstens einen ohmschen Kontakt durch eine horizontale Bewegung der beweglichen Elemente in einer Ebene des Substrats (15) zu schließen und zu lösen; wobei die Schaltvorrichtung (1) aufweist:

einen Antrieb mit kammförmigen Elektroden (2, 3), wobei
die Elektroden (2, 3) feste, antreibende Elektroden (2) und bewegliche Elektroden (3) umfassen;
eine bewegliche Schubstange (4), die mechanisch mit den beweglichen Elektroden (3) verbunden ist und sich durch die Elektroden (2, 3) erstreckt;
ein bewegliches Kontaktelement, das mechanisch mit einer Seite der Schubstange (4) verbunden ist, wobei das Kontaktelement einen beweglichen Kontaktbalken (6) aufweist,
wobei sich der bewegliche Kontaktbalken (6) zumindest teilweise gegenüber der Signalleitung (7) erstreckt;
wenigstens eine Rückstellfeder (5), die mechanisch mit der Schubstange (4) verbunden ist;
eine Signalleitung (7) und eine Masseleitung (13), wobei
die Signalleitung (7) zwei Teile (7a, 7b) aufweist, die durch einen Spalt (10) unterbrochen sind, wobei die Masseleitung (13) wenigstens einen Kontaktstab aufweist, der durch den Spalt der Signalleitung (7) führt, und wobei
eine Kontaktmetallisierung (14) zumindest oben und an den Seitenwänden des Kontaktbalkens (6), der Signalleitung (7) und der Masseleitung (13) vorgesehen ist,

**dadurch gekennzeichnet,**
**dass** sich die Schaltvorrichtung (1) in einer Nebenschlusskonfiguration zum Schließen und Lösen des ohmschen Kontakts zwischen der Masseleitung (13) und der Signalleitung (7) befindet, wobei der bewegliche Kontaktbalken (6) elektrisch und mechanisch an jeweils beide Teile (7a, 7b) der Signalleitung (7) angeschlossen ist; und
der wenigstens eine Kontaktstab (12) durch den Spalt (10) der Signalleitung (7) führt, um den ohmschen Kontakt zwischen dem Kontaktbalken (6) und der Masseleitung (13) zu bilden.

2. Schaltvorrichtung nach Anspruch 1, **dadurch gekennzeichnet, dass** ein beweglicher Rahmen (18) an einem festen Ende (21) jeder Rückstellfeder (5) vorgesehen ist und zumindest teilweise ein festes Haftunterlager (20) umgibt, wobei sich der bewegliche Rahmen (18) gegenüber wenigstens einer zusätzlichen Anziehungselektrode (19) befindet und elastisch aufgehängt ist, sodass sich der bewegliche Rahmen (18) zu dem Haftunterlager (20) bewegt, wenn eine Aktivierungsspannung ($V_{GR}$) an die zusätzliche Anziehungselektrode (19) angelegt wird, wobei der bewegliche Rahmen (18) an dem Haftunterlager (20) auf der Seite der Verbindung des beweglichen Rahmens (18) und der Rückstellfeder (5) zum Stillstand (22) kommt, und wobei das Haftunterlager (20) und der bewegliche Rahmen (18) durch Mikroschweißung in dieser Konstellation dauerhaft verbunden sind.

3. Schaltvorrichtung nach Anspruch 2, **dadurch gekennzeichnet, dass** die Haftunterlager (20) eine Dotierung an ihrer Oberseite aufweisen, die stärker ist als die Dotierung des Materials des Substrats (15) der Schaltvorrichtung (1 b).

4. Schaltvorrichtung nach wenigstens einem der Ansprüche 2 oder 3, **dadurch gekennzeichnet, dass** der bewegliche Rahmen (18) in zwei Abschnitte unterteilt ist.

5. Schaltvorrichtung nach wenigstens einem der Ansprüche 2 bis 4, **dadurch gekennzeichnet, dass** die Seite des beweglichen Rahmens (18), die zur zusätzlichen Anziehungselektrode (19) hin gewandt ist, im Vergleich zu dessen anderen Seiten breiter ist.

6. Schaltvorrichtung nach wenigstens einem der vorhergehenden Ansprüche, **dadurch gekennzeichnet, dass** Metallbrücken (23), die durch Unterätzen vom Substrat (15) freigelegt sind, zwischen elektrischen Leitungen vorgesehen sind, die während der Fertigung und/oder Handhabung der Schaltvorrichtung (1c) elektrisch an die festen Elektroden (2) und die beweglichen Elektroden (3) angeschlossen werden.

7. Schaltvorrichtung nach wenigstens einem der vorhergehenden Ansprüche, **dadurch gekennzeichnet, dass** Metallbrücken (24), die durch Unterätzen vom Substrat (15) freigelegt sind, zwischen elektrischen Leitungen vorgesehen sind, die während der Fertigung und/oder Handhabung der Schaltvorrichtung (1 c) elektrisch an die Signalleitung (7) und die Masseleitung (13) angeschlossen werden.

8. Schaltvorrichtung nach wenigstens einem der vorhergehenden Ansprüche, **dadurch gekennzeichnet, dass** elektrische Leitungen, die an die feststehenden Elektroden (2) und die beweglichen Elektroden (3) bzw. die Signalleitung (7) und die Masseleitung (13) angeschlossen sind, durch Kontaktfenster (27) in einer Isolierschicht (25) der Schaltvorrichtung (1d) und eine anschließende Metallisierung während der Handhabung und/oder Scheibenniveauverkapselung der Schaltvorrichtung (1d) elektrisch am Material des Substrats (15) angeschlossen werden.

9. Schaltvorrichtung nach Anspruch 8, **dadurch gekennzeichnet, dass** wenigstens eine Metallbrücke (28) mit Unterschnitt (29) in den Verbindungsweg zu den Kontaktfenstern (27) eingesetzt ist.

10. Schaltvorrichtung nach Anspruch 8 oder 9, **dadurch gekennzeichnet, dass** die Kontaktfenster (27) durch eine lokal dotierte Zone an einer Oberseite des Substrats (15) gebildet sind, die lokal dotierte Zone temporär durch ein Metall angeschlossen ist, wobei das Metall eine Öffnung (31) über der dotierten Zone aufweist, und wobei die dotierte Zone nach dem Kontaktieren der Schaltvorrichtung (1) zumindest teilweise entfernt ist, um einen Kurzschluss zwischen Metall und Masse zu unterbrechen.

11. Schaltvorrichtung nach wenigstens einem der vorhergehenden Ansprüche, **dadurch gekennzeichnet, dass** die Elektroden (2, 3) aus Silizium bestehen, wobei das Siliziummaterial im Bereich des Antriebs lokal dotiert ist.

12. Schaltvorrichtung nach wenigstens einem der vorhergehenden Ansprüche, **dadurch gekennzeichnet, dass** ein elektrisches Trägerelement (32) zwischen der Schubstange (4) und einer oder mehreren Kontaktspitze(n) (8) des Kontaktträgers (6) vorgesehen ist, wobei die Masse der Schubstange (4) und der beweglichen Elektroden (3) mindestens dreimal größer ist als die Masse des Kontaktbalkens (6) und der Kontaktspitze(n) (8).

13. Schaltvorrichtung nach wenigstens einem der vorhergehenden Ansprüche, **dadurch gekennzeichnet, dass** die Signalleitung (7) und/oder die Masseleitung (13) an einer Stelle der Kontaktmetallisierung (14) in zwei Seiten von Streifen (34) unterteilt sind, wobei die Streifen (34) in ihrer Tiefe von dem Substrat (15) getrennt sind.

14. Schaltvorrichtung nach wenigstens einem der vorhergehenden Ansprüche, **dadurch gekennzeichnet, dass** Leitungen zu elektrischen Anschlüssen der Schaltvorrichtung (1) in flachen Gräben innerhalb eines Dichtungsbereichs der Schaltvorrichtung (1) angeordnet und durch eine Isolierschicht zum Substrat (15) und eine weitere, die Leitungen bedeckende Isolierschicht isoliert sind, wobei die weitere Isolierschicht teilweise entfernt ist, sodass die Oberfläche des Substrats (15) im Leitungsbereich flach ist.

15. Schaltvorrichtung nach wenigstens einem der vorhergehenden Ansprüche, **dadurch gekennzeichnet, dass** die Masseleitung (13) durch einen Schlitz (13a) geteilt ist, der sich in der Richtung der Schubstange (4) erstreckt.

16. Schaltvorrichtung nach wenigstens einem der vorhergehenden Ansprüche, **dadurch gekennzeichnet, dass** die Signalleitung (7) an zwei Stellen jeweils durch einen Spalt (10) unterbrochen ist, und dass es zwei Kontaktelemente gibt, die jeweils einen beweglichen Balken (6) aufweisen, der sich zumindest teilweise gegenüber der Signalleitung (7) erstreckt und elektrisch und mechanisch an beide Teile der Signalleitung (7) angeschlossen ist, und auch mechanisch an die Schubstange (4) angeschlossen und deshalb synchron durch die beweglichen Elektroden (3) angetrieben ist, wobei die Masseleitung (13) mindestens einen Kontaktstab an der Stelle jedes Spalts (10) der Signalleitung (7) aufweist, um den ohmschen Kontakt zwischen dem Kontaktträger (6) und der Masseleitung (13) zu bilden.

## Revendications

1. Dispositif de commutation micromécanique actionné électrostatiquement (1) doté d'éléments mobiles formés dans le volume d'un substrat (15) afin de fermer et libérer au moins un contact ohmique par un mouvement horizontal des éléments mobiles dans un plan du substrat (15), le dispositif de commutation (1) comprenant :

   un pilote doté d'électrodes en forme de peigne (2, 3), dans lequel les électrodes (2, 3) comprennent des électrodes d'entraînement fixes (2) et des électrodes mobiles (3) ;
   une tige poussoir mobile (4) étant mécaniquement raccordée aux électrodes mobiles (3) et s'étendant à travers les électrodes (2, 3) ;
   un élément de contact mobile étant mécaniquement raccordé à un côté de la tige poussoir (4), dans lequel l'élément de contact comprend une lame de contact mobile (6), dans lequel la lame de contact mobile (6) s'étend au moins partiellement opposée à la ligne de signal (7) ;
   au moins un ressort de rappel (5) étant mécaniquement raccordé à la tige poussoir (4) ;
   une ligne de signal (7) et une ligne terrestre (13), dans lequel la ligne de signal (7) comprend deux parties (7a, 7b) interrompues par un écartement (10), dans lequel la ligne terrestre (13) comprend au moins une barre de contact menant à travers l'écartement de la ligne de signal (7), et dans lequel une métallisation de contact (14) est agencée au moins au-dessus et sur les parois latérales de la lame de contact (6), de la ligne de signal (7) et de la ligne terrestre (13),
   **caractérisé en ce que**
   le dispositif de commutation (1) est en configuration de shunt afin de fermer et libérer le contact ohmique entre la ligne terrestre (13) et la ligne de signal (7), dans lequel
   la lame de contact mobile (6) est connectée électriquement et raccordée mécaniquement aux deux parties (7a, 7b) de la ligne de signal (7), respectivement ; et
   la au moins une barre de contact (12) menant à travers l'écartement (10) de la ligne de signal (7) afin de former le contact ohmique entre la lame de contact (6) et la ligne terrestre (13).

2. Dispositif de commutation selon la revendication 1, **caractérisé en ce qu'**une monture mobile (18) est agencée au niveau d'une extrémité fixe (21) de chaque ressort de rappel (5) et entoure au moins partiellement un patin adhésif fixe (20), dans lequel la monture mobile (18) est opposée à moins une électrode d'attraction supplémentaire (19) et suspendue élastiquequement de sorte que la monture mobile (18) se déplace vers le patin adhésif (20) lorsqu'une tension d'activation ($V_{GR}$) est appliquée à l'électrode d'attraction supplémentaire (19), dans lequel la monture mobile (18) vient reposer (22) au niveau du patin adhésif (20) du côté de connexion entre la monture mobile (18) et le ressort de rappel (5), et dans lequel le patin adhésif (20) et la monture mobile (18) sont reliés de façon permanente dans cette constellation par microsoudage.

3. Dispositif de commutation selon la revendication 2, **caractérisé en ce que** les patins adhésifs (20) comprennent un dopage au niveau de leur surface supérieure qui est supérieur au dopage du matériau de substrat (15) du dispositif de commutation (1 b).

4. Dispositif de commutation selon au moins l'une des revendications 2 ou 3, **caractérisé en ce que** la monture mobile (18) est divisée en deux sections.

5. Dispositif de commutation selon au moins l'une des revendications 2 à 4, **caractérisé en ce que** le côté de la monture mobile (18) qui fait face à l'électrode d'attraction supplémentaire (19) est plus large comparé à ses autres côtés.

6. Dispositif de commutation selon au moins l'une des revendications précédentes, **caractérisé en ce que** des ponts métalliques (23) libérés du substrat (15) par sous-gravure sont agencés entre des lignes électriques qui sont électriquement connectées aux électrodes fixes (2) et aux électrodes mobiles (3) pendant la fabrication et/ou la manipulation du dispositif de commutation (1c).

7. Dispositif de commutation selon au moins l'une des revendications précédentes, **caractérisé en ce que** des ponts métalliques (24) libérés du substrat (15) par sous-gravure sont agencés entre des lignes électriques qui sont électriquement connectées à la ligne de signal (7) et la ligne terrestre (13) pendant la fabrication et/ou la manipulation du dispositif de commutation (1c).

8. Dispositif de commutation selon au moins l'une des revendications précédentes, **caractérisé en ce que** des lignes électriques qui sont connectées aux électrodes fixes (2) et aux électrodes mobiles (3), et à la ligne de signal (7) et à la ligne terrestre (13), respectivement, sont électriquement connectées par des fenêtres de contact (27) dans une couche d'isolement (25) du dispositif de commutation (1d) et la métallisation ultérieure au matériau de substrat (15) pendant la manipulation et/ou encapsulation sur tranche du dispositif de commutation (1d).

9. Dispositif de commutation selon la revendication 8, **caractérisé en ce qu'**au moins un pont métallique (28) doté d'un caniveau (29) est inséré dans le chemin de connexion aux fenêtres de contact (27).

10. Dispositif de commutation selon la revendication 8 ou 9, **caractérisé en ce que** les fenêtres de contact (27) sont formées par une région localement dopée au niveau d'une surface supérieure du substrat (15), la région localement dopée étant temporairement connectée par un métal, dans lequel le métal comprend une ouverture (31) sur la région dopée, et dans lequel la région dopée est au moins partiellement éliminée après liaison du dispositif de commutation (1) afin de couper un court-circuit entre le métal et le volume.

11. Dispositif de commutation selon au moins l'une quelconque des revendications précédentes, **caractérisé en ce que** les électrodes (2, 3) consistent en du silicium, dans lequel le matériau de silicium est localement dopé dans la zone du pilote.

12. Dispositif de commutation selon au moins l'une quelconque des revendications précédentes, **caractérisé en ce qu'**un élément de lame élastique (32) est agencé entre la tige poussoir (4) et une ou des pointes de contact (8) de la lame de contact (6), dans lequel la masse de la tige poussoir (4) et des électrodes mobiles (3) est plus de trois fois supérieure à la masse de la lame de contact (6) et de la ou les pointes de contact (8).

13. Dispositif de commutation selon au moins l'une des revendications précédentes, **caractérisé en ce que** la ligne de signal (7) et/ou la ligne terrestre (13) sont divisées en deux côtés de barrettes (34) en un emplacement de la métallisation de contact (14), dans lequel les barrettes (34) sont séparées du substrat (15) dans leur profondeur.

14. Dispositif de commutation selon au moins l'une des revendications précédentes, **caractérisé en ce que** des lignes vers des bornes électriques du dispositif de commutation (1) sont agencées en rainures plates au sein d'une zone d'étanchéité du dispositif de commutation (1) et sont isolées par une couche d'isolement vers le substrat (15) et une couche d'isolement supplémentaire couvrant les lignes, dans lequel la couche d'isolement supplémentaire est en partie éliminée de sorte que la surface du substrat (15) est plate dans la région de la ligne.

15. Dispositif de commutation selon au moins l'une des revendications précédentes, **caractérisé en ce que** la ligne terrestre (13) est coupée par une fente (13a) s'étendant dans la direction de la tige poussoir (4).

16. Dispositif de commutation selon au moins l'une des revendications précédentes, **caractérisé en ce que** la ligne de signal (7) est interrompue en deux emplacements par un écartement (10) respectivement, et **en ce qu'**il y a deux éléments de contact comprenant chacun une lame mobile (6) s'étendant au moins partiellement opposée à la ligne de signal (7) et étant électriquement connectée et mécaniquement raccordée aux deux parties de la ligne de signal (7), et également mécaniquement raccordée à la tige poussoir (4) et donc entraînée de façon synchrone par les électrodes mobiles (3) ; dans lequel la ligne terrestre (13) comprend au moins une barre de contact au niveau de l'emplacement de chaque écartement (10) de la ligne de signal (7) afin de former le contact ohmique entre la lame de contact (6) et la ligne terrestre (13).

Fig.1

Simplified electrical model

Symmetry plane

Illustration of expected current flow

A-A

Fig.2

Fig.3

Fig.4

Fig.5

Fig.6

1e

$R{\downarrow}$

$R{\uparrow}$

$R{\sim}0$

Cross
section:

15a

15

14

Fig.7

15

1f

7a

13

5

5

5

32

8

4

6

8

3

2

12

7b

Fig.8

Fig.9

Fig.10

$F_{r1,4}$

$F_{cr1}$ $F_{cr2}$

1f

$F_{cr1}$

$v$

$m$

$F_{cr2}$

Fig.11

5

5

14

1

7a

5

13

4

12

6

33

3 2

7b

Fig.12

22

Fig.13

Fig.14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090219113 A1
- DE 602005002277 T2
- US 2003098618 A1
- US 20050099252 A1
- WO 2008110389 A1